# EUROPEAN PATENT APPLICATION

(11) **EP 1 139 389 A1**
(43) Date of publication of application: **04.10.2001**
(21) Application number: 00106632.3
(22) Date of filing: 28.03.2000
(51) Int. Cl.: H01L 21/00

(54) **Arrangement for etching a semiconductor substrate and method for cleaning a filter in the arrangement**

(71) Applicant: Infineon Technologies AG, 81669 München (DE); Semiconductor 300 GmbH & Co. KG, 01074 Dresden (DE); MOTOROLA, INC., Schaumburg, IL 60196 (US)
(72) Inventor: Ottow, Stefan, Dr., 01109 Dresden (DE); Wissel, Dan, 01277 Dresden (DE)
(74) Representative: Hermann, Uwe, Dipl.-Ing.

(57) **Abstract**

An arrangement for etching a semiconductor substrate (15) is disclosed, comprising a filter (1), a process basin (14) and a valve. The process basin (14) contains an etching substance (24) for etching the semiconductor substrate (15). The filter (1) cleans the etching substance (24). The valve is operated in a first position to filter the etching substance (24) while the etching substance (24) is flowing from a process inflow (2) through the filter (1) to a process outflow (3) to etch the semiconductor substrate (15). The valve is operated in a second position to clean the filter (1) with a cleaning substance (25) flowing from a cleaning inflow (4) through the filter (1) to a cleaning outflow (5). Thereby the filter lifetime is increased.

## Description

The present invention refers to an arrangement for etching a semiconductor substrate and a method for cleaning a filter in said arrangement.

Filters are used for purifying a solution by removing particles which exist in the solution. For example, a filter can be used in a semiconductor factory to purify an etching solution consisting of an aqueous phosphoric acid solution which has been used for the etching of a silicon-nitride film formed on a semiconductor wafer. This technique is described in the patent US 5,420,421.

A problem that arises when using a filter is that the filter has a limited lifetime due to contamination with the filtered particles. As a result, the filter has to be exchanged for a new one. The fittings for some filters are made of steel, but steel is not a favourable material for semiconductor manufacturing, because it can contaminate the wafer. Therefore other filters are made from synthetic materials which are somehow softer and can be damaged during installation or removal so that they cannot be recycled.

It is an objective of the present invention to provide an arrangement for etching a semiconductor substrate and a method which enable the prolongation of the working lifetime of a filter.

To attain the above mentioned objective, an arrangement for etching a semiconductor substrate is provided comprising: a process basin to receive a wafer substrate, a filter connected to the process basin, a process inflow connected to said filter, a process outflow connected to said filter, a cleaning inflow and a cleaning outflow connected to said filter and a valve with a first and a second operating position connected to said filter, in that in said first operating position an etching substance can flow from the process inflow through the filter to the process outflow and in said second operating position a cleaning substance can flow from the cleaning inflow through the filter to the cleaning outflow.

In this configuration the filter can be operated in a processing circulation for cleaning a processing substance which is flowing through the filter. By operating the valves the flow of the processing substance through the filter can be interrupted, so that the filter is separated from the process circulation, which is interrupted. Further the valves are operated in a way that a cleaning substance which cleans the filter can flow through the filter. For example, the cleaning substance can flow through the filter in the same or the opposite direction as the processing substance. An advantage of this arrangement is that the filter can be cleaned without being removed from the arrangement.

In an embodiment of the invention the process basin containing the processing substance for processing a wafer substrate is connected to the filter. The process basin is the place where the wafer substrate is processed. For example some particles which are removed from the substrate are present in the processing substance afterwards. The processing substance can then be cleaned with the filter by removing the particles from the processing substance.

A further embodiment of the invention contains a pump which is connected to the process basin and the filter to establish a process circulation. The processing substance circulates in the process circulation for maintaining a pure processing substance. For example, the processing substance flows out of the processing basin and is pumped with the pump through the filter. The filter cleans the processing substance, which flows back into the process basin. The advantage of this circulation is that the processing substance is continuously cleaned by the filter, while cycling in the circulation.

In another embodiment of the invention the processing substance contains phosphoric acid. Phosphoric acid can be used for etching silicon-nitride which is formed on a wafer substrate.

According to another embodiment of the invention the cleaning substance contains hydrofluoric acid. The etching of silicon-nitride with phosphoric acid can be described with the following reaction equation: Si₃N₄ + 6H₂O reacts under the effect of H₃PO₄ to 3SiO₂ + 4NH₃. As a result residues of SiO₂ remain in the phosphoric acid. These residues are collected in the filter and can block up the filter after a certain range of time. As the residues consist of silicon-dioxide they can be dissolved with hydrofluoric acid and the filter is advantageously cleaned.

A further embodiment of the invention connects a tank to the filter. The tank is used for flushing the processing substance out of the processing circulation into the tank. When the processing substance contains phosphoric acid it is normally heated to a temperature above the boiling point at a certain concentration e.g. 160 °C. The tank can be used as a cooling down tank for the processing substance, before the processing substance is forwarded to a drain or a neutralization.

Furthermore, it is preferable to attach a supply for a rinsing substance to the cleaning inflow. The rinsing substance can be used to remove the hydrofluoric acid from the filter after cleaning it.

Advantageously the cleaning inflow and the cleaning outflow are connected and establish a cleaning circulation. This arrangement can be used to circulate the cleaning substance in the cleaning circulation and the filter is continuously penetrated by the cleaning substance.

According to another embodiment of the invention a second pump is connected to the cleaning inflow. The second pump is used to circulate the cleaning substance in the cleaning circulation and to force the cleaning substance through the filter.

In a further embodiment of the invention a second filter is connected to the process inflow and the process outflow so that the first filter and the second filter can alternately clean the processing substance or can be cleaned by the cleaning substance. The second filter is cleaned while the first filter is operating and vice versa. With this arrangement the substrate processing is not interrupted by the filter cleaning process. Valves and tubes are foreseen in an arrangement, that allows the cleaning and rinsing of one filter while the other filter is cleaning the processing substance.

To obtain the above mentioned objective concerning the method, a method for cleaning a filter in an above mentioned arrangement for etching a semiconductor substrate is provided wherein a valve is operated in a first position to filter a processing substance while the etching substance is flowing from a process inflow through the filter to a process outflow to etch a semiconductor substrate and the valve is operated in a second position to clean the filter with a cleaning substance flowing from a cleaning inflow through the filter to a cleaning outflow.

This method cleans a filter without disassembling the filter from the system. This reduces the time needed for cleaning the filter. With this method it is also possible to clean filters which are mechanically weak and cannot be mounted to the processing circulation a second time. This recycling of a filter saves filter costs.

Further embodiments of the invention are given in the dependent claims.

The invention is further explained using examples with reference to figures.

The figures show:
- Figure 1: a filter to be used in an arrangement according to the invention;
- Figure 2: another arrangement of the filter;
- Figure 3: another arrangement of the filter;
- Figure 4: an arrangement of the filter with a processing circulation and a cleaning means;
- Figures 5 to 9: an arrangement of a filter, a processing circulation and a cleaning circulation where the different steps for operating the arrangement are shown in the successive figures;
- Figures 10 to 13: an arrangement of a filter, a processing circulation and a cleaning circulation, where the two filters are cleaned and operated alternatively.

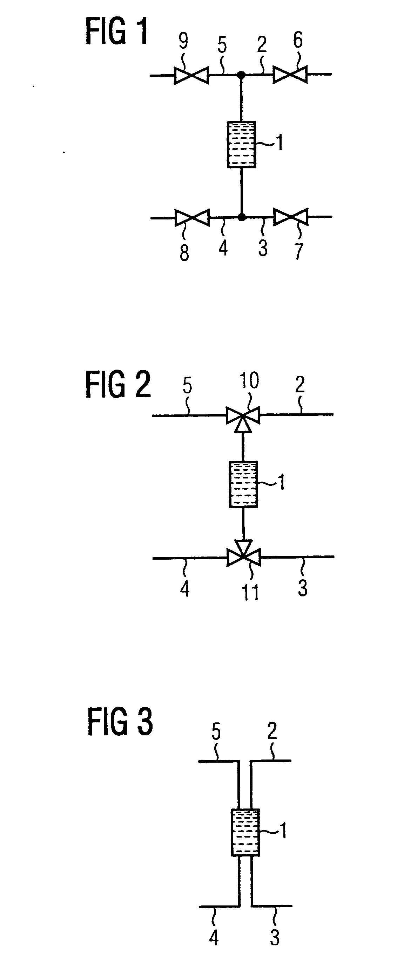

In figure 1 a filter 1 is connected to a process inflow 2, a process outflow 3, a cleaning inflow 4 and a cleaning outflow 5. The process inflow 2 can be opened and closed with the first valve 6, the process outflow 3 can be opened and closed with the second valve 7, the cleaning inflow 4 can be opened and closed with the third valve 8 and the cleaning outflow 5 can be opened and closed with the fourth valve 9. In the arrangement of figure 1 the process inflow 2 is at the opposite side to the cleaning inflow 4. That means that the cleaning flow direction for cleaning the filter 1 is opposite to the process flow direction.

Figure 2 shows a second example of the invention where the filter 1 is connected to a process inflow 2, a process outflow 3, a cleaning inflow 4 and a cleaning outflow 5. Additionally there is a fifth valve 10 which can alternate the flow to the filter 1 between the process inflow 2 and the cleaning outflow 5. A sixth valve 11 is connected to the filter 1 and can alternate the substance flow through the filter between the process outflow 3 and the cleaning inflow 4. In this example the process flow direction is opposite to the cleaning flow direction through the filter. It is also possible to build the cleaning flow direction in the same direction through the filter as the processing flow direction.

Figure 3 shows a third example of the invention, comprising a filter 1 which is connected to a process inflow 2, a process outflow 3, a cleaning inflow 4 and a cleaning outflow 5. In figure 3 no valves are shown because the valves can be arranged in other parts of the system.

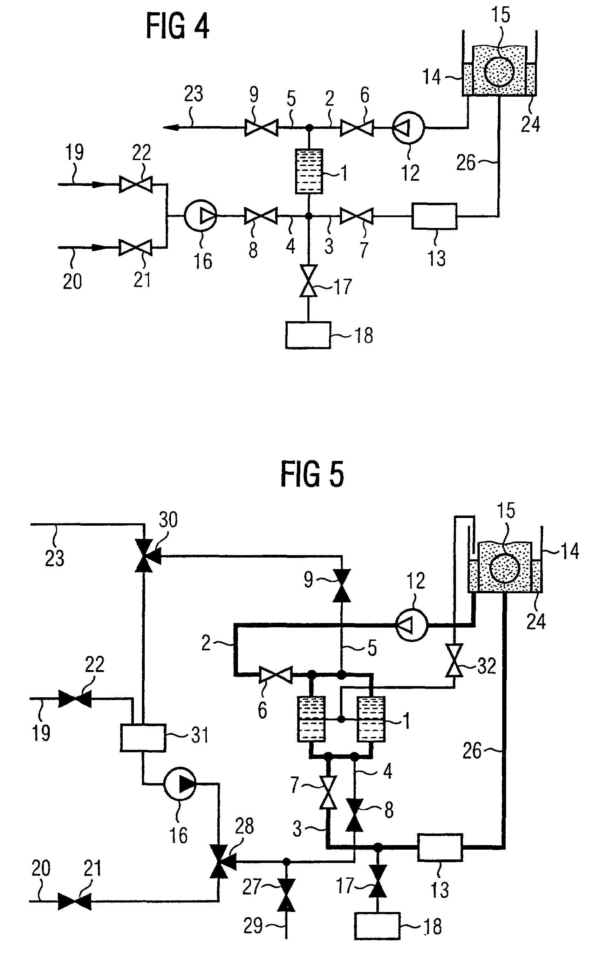

Figure 4 is an example of the invented filter with a processing circulation and a cleaning circulation. The filter 1 is connected to a process inflow 2 which can be opened and closed by the first valve 6, connected to a process outflow 3 which can be opened and closed with a second valve 7, connected to a cleaning inflow 4 which can be opened and closed with a third valve 8 and connected to a cleaning outflow 5 which can be opened and closed with a fourth valve 9. Connected to the process inflow 2 is a pump 12 which is also connected to the process basin 14. The process basin 14 contains a processing substance 24 and a wafer substrate 15 which is processed with the processing substance 24. In this example the processing substance 24 is comprising phosphoric acid and is pumped with the help of the pump 12 through the filter 1. Afterwards it flows out of the filter through the process outflow 3 and through a heater 13, which helps to heat the processing substance 24 to an adequate temperature. The heater 13 itself is connected to the process basin 14, so that the filtered processing substance 24 can flow back into the process basin 14. After a certain amount of time the processing substance 24 is consumed and it has to be replaced with a new processing substance. In this case the seventh valve 17, which is connected to the filter, is opened and the processing substance 24 flows through the seventh valve 17 into a tank 18. The tank 18 can be used to cool down the processing substance 24 before draining, neutralising or recycling it.

After a certain amount of time the filter 1 can be blocked so that it is necessary to clean it. For this purpose the first valve 6 and the second valve 7 are closed and the fourth valve 9 and the third valve 8 are opened to open the cleaning inflow 4 and the cleaning outflow 5. Connected to the cleaning outflow 5 is a drain 23 where the cleaning substance can be drained. Connected to the cleaning inflow 4 is a second pump 16, which can pump a cleaning substance 25 and a rinsing substance 41 through the filter 1. In figure 4 the second pump 16 is connected to an eighth valve 21 which opens a supply 20 for a rinsing substance and is connected to a ninth valve 22 which is connected to a supply for a cleaning substance 19. To clean the filter 1 the cleaning substance 25 is pumped through the filter 1 to remove the blocking particles in the filter through the cleaning outflow into the drain 23. Afterwards the filter 1 is rinsed with a rinsing substance 41 to remove the cleaning substance 25 from the filter 1.

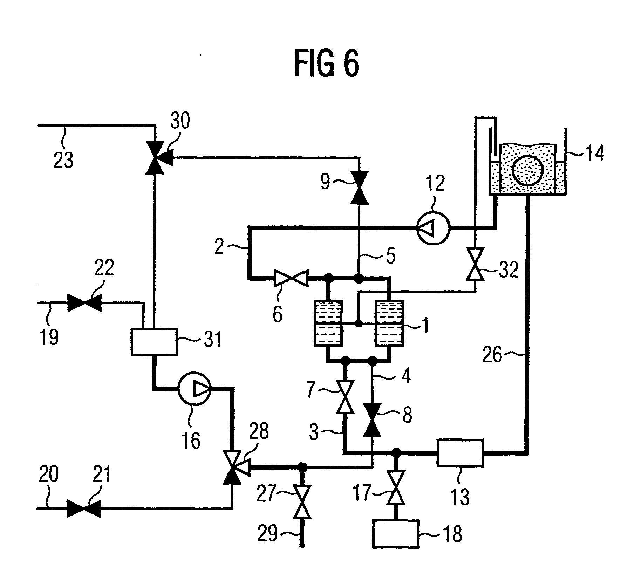

In figures 5 to 7 the same arrangement is shown. The difference between the figures 5 to 7 is in the state in which the arrangement is working at each particular figure. In the figures the blocked valves are drawn in black, the open valves are drawn with a white body. The active pump is also drawn with a white triangle in it, the blocking pump is drawn with a black one. The tubes which are transporting fluid are drawn with big grey lines, the other tubes which are not transporting a substance in this state are drawn with small black lines.

In figure 5 there is a filter 1 which is connected to a process inflow 2 and a process outflow 3. The process inflow 2 can be opened and closed with the first valve 6, the process outflow 3 can be opened and closed with the second valve 7. The process inflow 2 is connected to a pump 12 where the triangle gives the pump direction. The pump 12 is connected to the process basin 14, which contains a processing substance 24 and a wafer substrate 15. The process outflow 3 is connected to a heater 13 where the processing substance 24 is heated while flowing through and forwarded to the process basin 14. The process basin 14, the pump 12, the filter 1 and the heater 13 build a process circulation 26. The thirteens valve 32 is open to allow degassing of the filter 1. The filter 1 is also connected to a cleaning outflow 5, which can be opened and closed with a fourth valve 9. The fourth valve 9 is connected to a twelfth valve 30, where the substance flow can be directed to the drain 23 or a reclaim tank 31. The reclaim tank 31 is connected to a supply of a cleaning substance 19 which can be opened and closed with a ninth valve 22. The outflow of the reclaim tank 31 is connected to a second pump 16 which pumps the cleaning substance 25 to an eleventh valve 28 which is connected to a supply of a rinsing substance 20 which can be opened and closed with an eighth valve 21. The eleventh valve 28 forwards the substance further to a tenth valve 27 which is connected to a second drain 29 and also forwards the substance to the cleaning inflow 4 which can be opened and closed with the third valve 8. In figure 5 the process circulation 26 is active so that the processing substance 24 is flowing through the pump 12 forwarded to the process inflow 2 passing the first valve 6 and the filter 1 and leaving the filter 1 through the second valve 7, being forwarded through the process outflow 3 to the heater 13 and flowing back into the process basin 14. The other valves in figure 5 are closed so that the other tubes are not forwarding a substance.

The next process step can be seen in figure 6 where the processing substance 24 is forwarded into the tank 18 through the open valve 17. The reclaim tank 31 is emptied through the second pump 16, the eleventh valve 28, the tenth valve 27 into the second drain 29. The processing substance 24 can be moved into the tank 18 by gravity. Also the emptying of the reclaim tank 31 into the second drain 29 can be done by gravity.

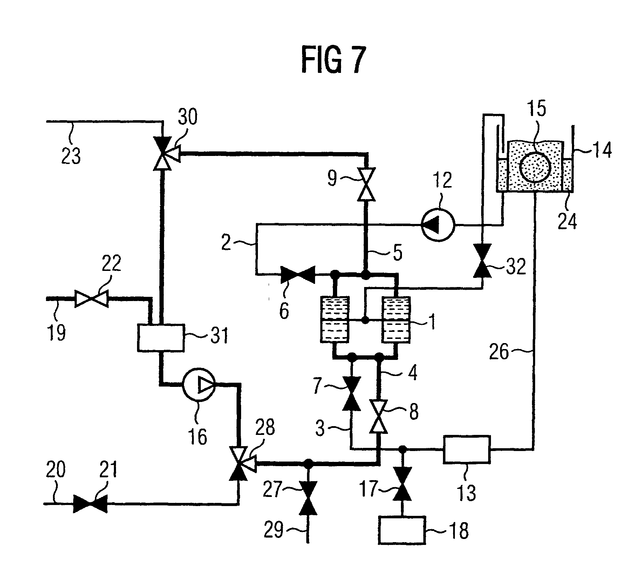

In the next process step, which is shown in figure 7, the first valve 6 and the second valve 7 are closed. That means, that the filter 1 is decoupled from the process circulation 26. Also the seventh valve 17 is closed so that the processing substance 24 remains in the tank 18. In addition, the thirteens valve 32 in closed so that the cleaning substance 25 can not enter the basis 14. The reclaim tank 31 is filled with the cleaning substance 25 from the supply for the cleaning substance 19 through the now open ninth valve 22. The cleaning substance is then proceeded through the working second pump 16 through the open eleventh valve 28 which has opened the direction from the reclaim tank 31 and not the direction from the supply for the rinsing substance 20. The cleaning substance 25 is further forwarded through the third valve 8 to the cleaning inflow 4. The cleaning substance is flowing through the filter 1 and cleans the filter 1. Also the tenth valve 27 is closed so that the second drain 29 is no longer active. The ninth valve 22 can be closed when the reclaim tank 31 is filled with enough cleaning substance. The fourth valve 9 and the twelfth valve 30 are open, so that the cleaning substance 25 can circulate through the filter 1, the reclaim tank 31 and the second pump 16.

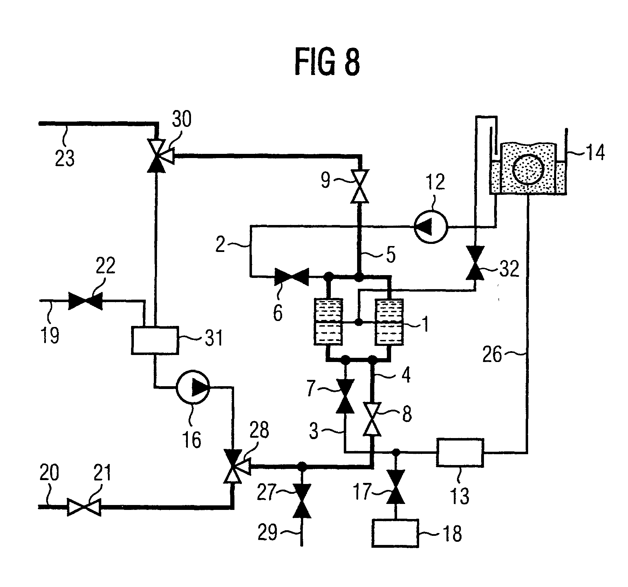

With respect to figure 8, the filter 1 is now being rinsed. For this purpose, the second pump 16 is shut down, the eleventh valve 28 is opened for the flow from the supply for the rinsing substance 20 through the eighth valve 22, and the twelfth valve 30 to the drain 23. The rinsing substance 41 is coming from the supply for the rinsing substance 20 and has enough pressure to go through the filter 1 and into the drain 23.

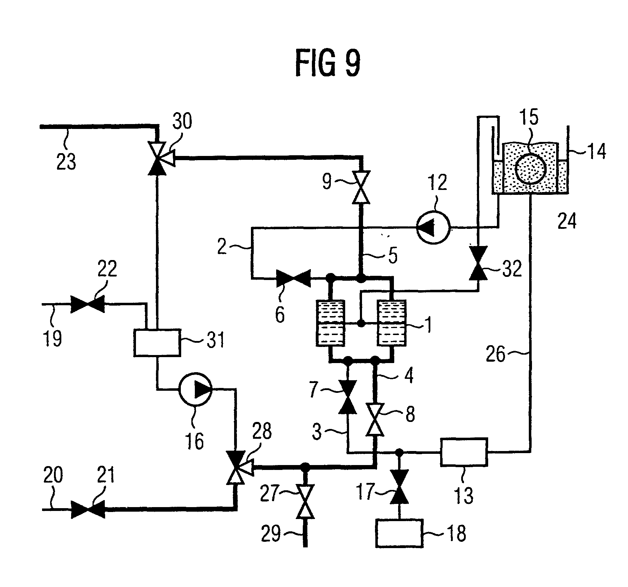

In figure 9, the eighth valve 21 is closed, so that no more rinsing substance 41 is flowing through the supply for the rinsing substance 20 into the cleaning circuit. The tenth valve 27 is opened, so that the rinsing substance 41 can flow into the second drain 29. The rinsing substance 41 flows into the second drain 29 and the drain 23 due to gravity, and the tubes and filters are emptied, leaving no rinsing substance behind.

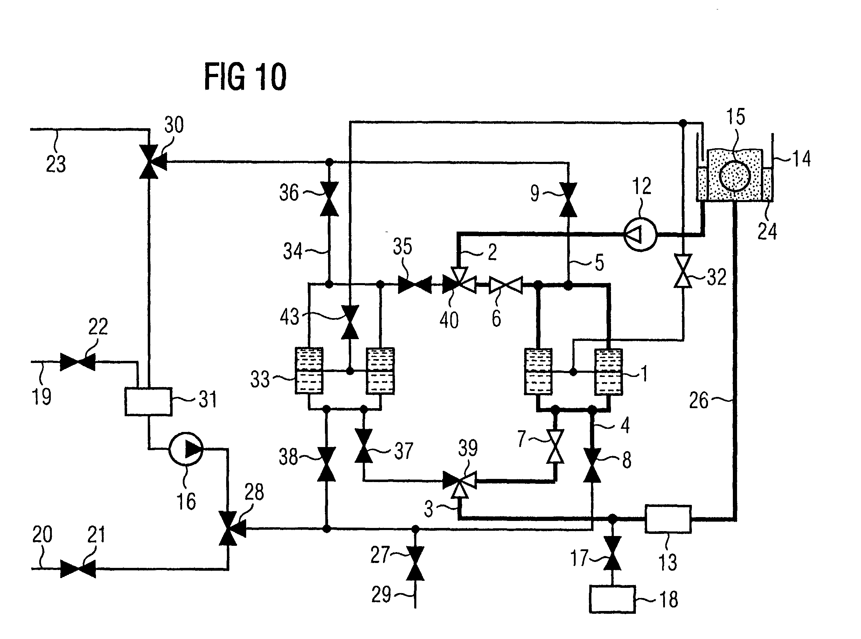

In the figures 10 to 14 is an example with two filters, a processing circulation and a cleaning circulation, where the two filters are cleaned and operated alternately. The arrangements in the figures 10 to 14 show the same arrangement in different operating states. In figure 10 the filter 1 is connected to a process inflow 2, a process outflow 3, a cleaning inflow 4 and a cleaning outflow 5. The process inflow 2 can be opened and closed with the first valve 6, the process outflow 3 can be opened and closed with the second valve 7, the cleaning inflow 4 can be opened and closed with the third valve 8 and the cleaning outflow 5 can be opened and closed with the fourth valve 9. The process inflow 2 is connected to a pump 12, which is itself connected to a process basin 14. The process basin 14 is filled with the processing substance 24, which is processing the wafer substrate 15. The process outflow 3 is connected to a heater 13, which is itself connected to the process basin 14. The thirteens valve 32 is open to allow dagssifying of the filter 1. In parallel to the filter 1, there is a second filter 33, which is also connected to the process inflow 2, which can be opened and closed with the fourteenth valve 35 and connected to the process outflow 3, which can be opened and closed with the sixteenth valve 37. The twentieth valve 43 is closed to prevent cleaning substance or rinsing substance from geing pumped into the basin 14. To distinguish between the first filter 1 and the second filter 33 there is a nineteenth valve 40 which can lead the processing substance 24 through the first or alternately through the second filter. The process outflow 3 can alternately be connected to the first filter 1 and the second filter 33 through the eighteenth valve 39.

A reclaim tank 31 is connected to a supply for a cleaning substance 19 which can be opened and closed with the ninth valve 22. The outflow of the reclaim tank 31 is connected to a second pump 16, which is itself connected to the first filter 1 through the third valve 8 and to the second filter 33 through the seventeenth valve 38. The cleaning outflow 5, which is connected to the first filter, can be opened and closed with the fourth valve 9 and is connected to the second cleaning outflow 34 through the fifteenth valve 36. The fourth valve 9 and the fifteenth valve 36 are connected to twelfth valve 30, which is itself connected to a drain 23 and the reclaim tank 31.

In figure 10 the process circulation 26 is active and processing substance 24 is flowing out of the process basin 14 through the pump 12 into the first filter 1 and out of the first filter 1 through the process outflow 3 to the heater 13, where the processing substance 24 is heated and afterwards reissued into the process basin 14.

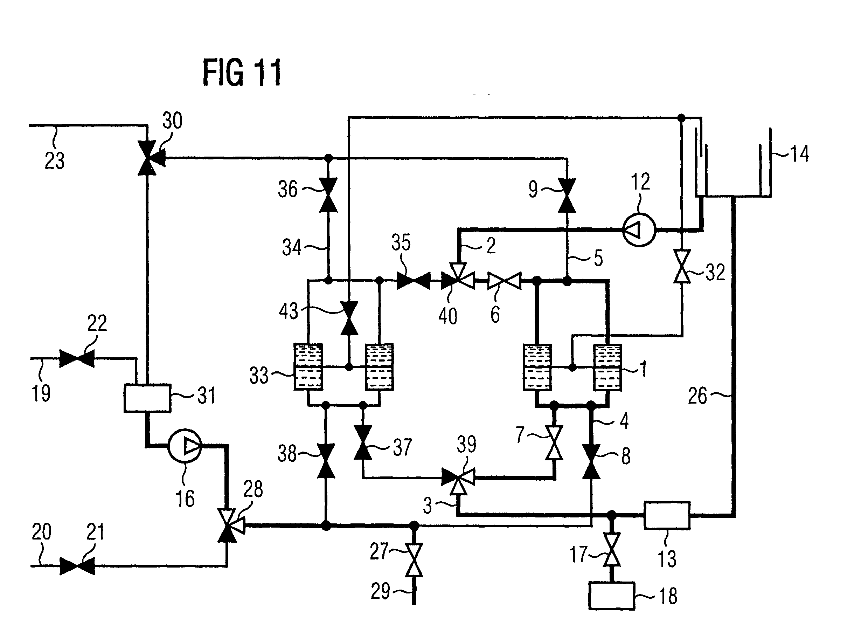

According to figure 11, the processing substance 24 is flushed through the seventh valve 17 into the tank 18. Also, the reclaim tank 31 is emptied through the second pump 16, the eleventh valve 28, the tenth valve 27 into the second drain 29.

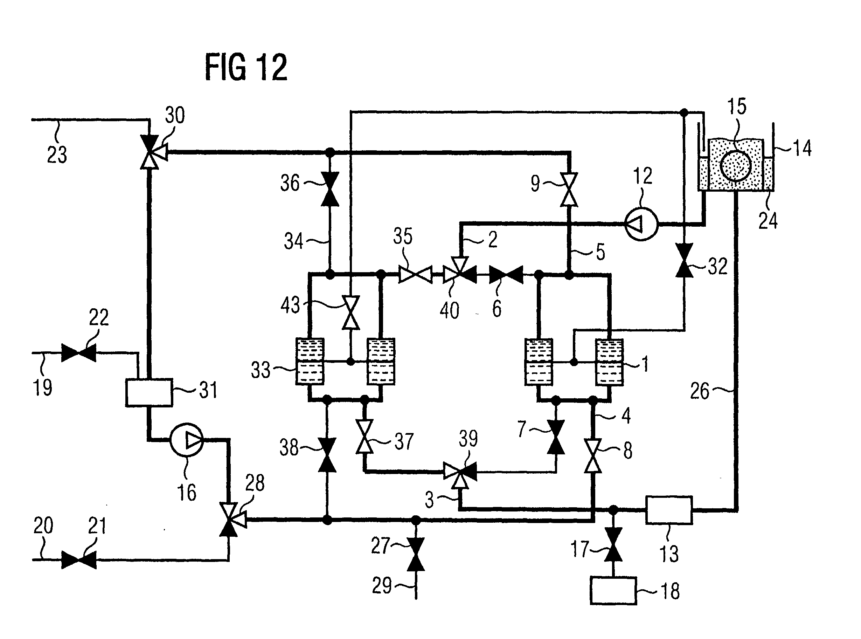

According to figure 12, a new processing substance 24 is filled into the process basin 14 as the processing substance 24 is in this case flowing from the process basin 14 through the pump 12 through the second filter 33 to the heater 13, where the processing substance is heated and flowing back into the process basin 14. The twentieth valve 42 is open to allow degassing of the filter 33. Also, the reclaim tank 31 has been filled with cleaning substance 25, which is flowing driven by the second pump 16 through the eleventh valve 28 and the third valve 8 into the filter 1, cleaning the filter 1, flowing through the cleaning outflow 5 and the fourth valve 9 and the twelfth valve 30 back into the reclaim tank 31. The thirteenth valve 32 is now closed to prevent cleaning substance 25 from being pumped into the process basin 14. Due to this process, the filter 1 is cleaned.

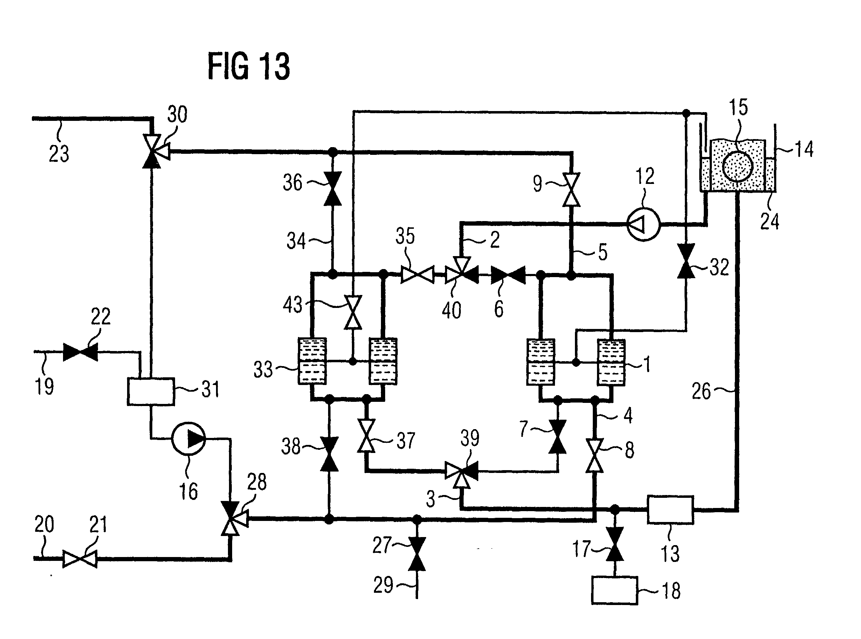

With respect to figure 13, the rinsing substance 41 is flowing from the supply for the rinsing substance 20 through the open third valve 8 through the eleventh valve 28, through the filter 1, through the cleaning outflow 5, through the open valve 9, through the open valve 30 into the drain 23. This process is rinsing the first filter 1, while the second filter 33 is still in process and is cleaning the processing substance 24.

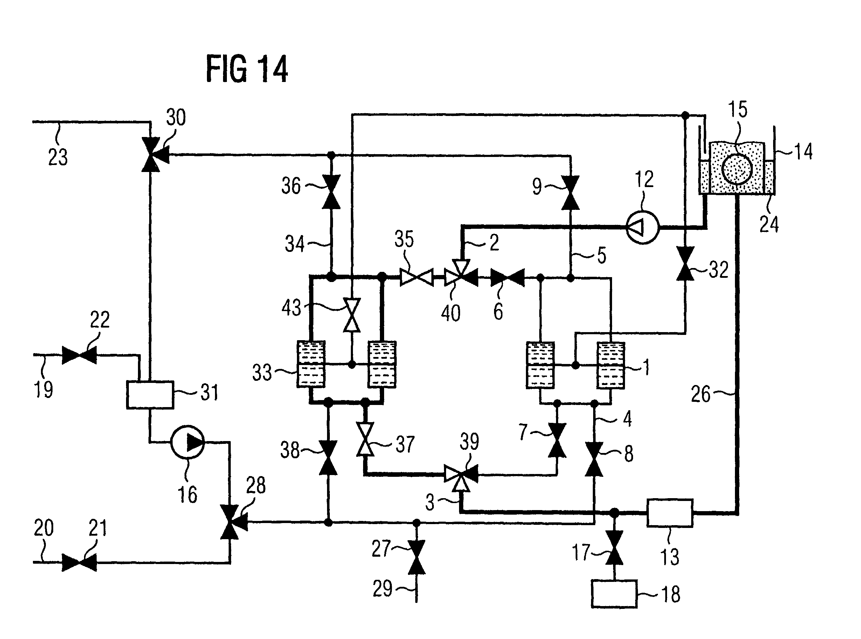

In figure 14, the rinsing process has been stopped and the well prepared filter 1 is ready for being used when the second filter 33 is blocked up by particles filtered out of the processing substance 24.

## Claims

1. Arrangement for etching a semiconductor substrate comprising:
- a process basin (14) to receive a wafer substrate (15);
- a filter (1) connected to the process basin (14);
- a process inflow (2) connected to said filter (1);
- a process outflow (3) connected to said filter (1);
**characterised in that**
a cleaning inflow (4) and a cleaning outflow (5) are connected to said filter (1) and a valve with a first and a second operating position is connected to said filter (1), **in that** in said first operating position an etching substance (24) can flow from the process inflow (2) through the filter (1) to the process outflow (3) and in said second operating position a cleaning substance (25) can flow from the cleaning inflow (4) through the filter (1) to the cleaning outflow (5).

2. Arrangement according to claim 1,
**characterised in that**
the process basin (14) contains the etching substance (24) for processing the wafer substrate (15).

3. Arrangement according to claim 1 or 2,
**characterised in that**
a pump (12) is connected to the process basin (14) and the filter (1) to establish a process circulation (26).

4. Arrangement according to claim 1 to 3,
**characterised in that**
the etching substance (24) contains phosphoric acid.

5. Arrangement according to claim 1 to 4,
**characterised in that**
the cleaning substance (25) contains hydrofluoric acid.

6. Arrangement according to claim 1 to 5,
**characterised in that**
a tank (18) is connected to the filter (1).

7. Arrangement according to claim 1 to 6,
**characterised in that**
a supply for a rinsing substance (20) is connected to the cleaning inflow (4).

8. Arrangement according to claim 1 to 7,
**characterised in that**
the cleaning inflow (4) and the cleaning outflow (5) are connected and establish a cleaning circulation (42).

9. Arrangement according to claim 1 to 8,
**characterised in that**
a second pump (16) is connected to the cleaning inflow (4).

10. Arrangement according to claim 1 to 9,
**characterised in that**
a second filter (23) is connected to the process inflow (2) and the process outflow (3), so that the filter (1) and the second filter (33) can alternately clean the etching substance (24) or be cleaned by the cleaning substance (25).

11. Method for cleaning a filter in an arrangement according to one of the claims 1 to 10,
**characterised in that**
a valve is operated in a first position to filter an etching substance (24) while the etching substance (24) is flowing from a process inflow (2) through the filter (1) to a process outflow (3) to etch a semiconductor substrate (15) and the valve is operated in a second position to clean the filter (1) with a cleaning substance (25) flowing from a cleaning inflow (4) through the filter (1) to a cleaning outflow (5).

12. Method according to claim 11,
**characterised in that**
a tank (18) is connected to the filter (1) and the etching substance (24) is filled into the tank (18) before the cleaning substance (25) flows through the filter (1).

13. Method according to claim 11 or 12,
**characterised in that**
a rinsing substance (41) is applied to the cleaning inflow (4) and the rinsing substance (41) is rinsing the filter (1).

14. Method according to claim 11 to 13,
**characterised in that**
a cleaning circulation (42) is established by operating a second pump (16) which is connected to the cleaning inflow (4) and the cleaning outflow (5), wherein the cleaning substance (25) is circulating driven by the second pump (16).
